# EUROPEAN PATENT APPLICATION

(11) **EP 4 808 323 A1**
(43) Date of publication of application: **16.09.2026**
(21) Application number: 26160730.3
(22) Date of filing: 25.02.2026
(51) Int. Cl.: H10K 59/122, H10K 59/80

(54) **DISPLAY DEVICE AND ELECTRONIC DEVICE INCLUDING THE SAME**

(30) Priority: 13.03.2025 KR 20250032896
(71) Applicant: Samsung Display Co., Ltd., Yongin-si, Gyeonggi-do 17113 (KR)
(72) Inventor: KIM, Jin Taek, 17113 Yongin-si (KR); PARK, Sang Ho, 17113 Yongin-si (KR); JUNG, Sug Woo, 17113 Yongin-si (KR); SON, Yong Duck, 17113 Yongin-si (KR); YOU, Chun Gi, 17113 Yongin-si (KR); LIM, Kyu Hun, 17113 Yongin-si (KR); HAN, Jeong Wan, 17113 Yongin-si (KR)
(74) Representative: Marks & Clerk LLP

(57) **Abstract**

A display device includes: a first anode and a second anode spaced apart from the first anode; and a pixel defining layer on the first anode and the second anode and including openings exposing portions of the first anode and the second anode, respectively, wherein the pixel defining layer comprises: a first pixel defining layer having a first taper angle and a first width; a second pixel defining layer on the first pixel defining layer and having a second taper angle and a second width less than the first width; and a third pixel defining layer on the second pixel defining layer and having a third taper angle and a third width, and wherein each of the first taper angle, the second taper angle, and the third taper angle is an acute angle.

## Description

### BACKGROUND

### 1. Field

Aspects of some embodiments of the present disclosure relate to a display device and an electronic device including the display device.

### 2. Description of the Related Art

With the development of information technologies, the importance of display devices, which provide a connection medium between users and information, has increased. Accordingly, various display devices, such as liquid crystal display devices and organic light emitting display devices, are increasingly being used.

The above information disclosed in this Background section is only for enhancement of understanding of the background and therefore the information discussed in this Background section does not necessarily constitute prior art.

### SUMMARY

Aspects of some embodiments of the present disclosure include a display device that may be capable of blocking leakage current between adjacent sub-pixels and reducing a step difference in a cathode, and an electronic device including the display device.

According to one or more embodiments of the present disclosure, a display device includes: a first anode and a second anode spaced apart from the first anode, and a pixel defining layer on the first anode and the second anode and including openings exposing portions of the first anode and the second anode, respectively. According to some embodiments, the pixel defining layer comprises: a first pixel defining layer having a first taper angle and a first width, a second pixel defining layer on the first pixel defining layer and having a second taper angle and a second width less than the first width, and a third pixel defining layer on the second pixel defining layer and having a third taper angle and a third width, and wherein each of the first taper angle, the second taper angle, and the third taper angle is an acute angle.

According to some embodiments, the third width may be less than the first width and greater than the second width.

According to some embodiments, a difference between a (1-1)th thickness of a first portion of the first pixel defining layer overlapping with the second pixel defining layer and the third pixel defining layer and a (1-2)th thickness of a second portion of the first pixel defining layer overlapping with the third pixel defining layer and not overlapping with the second pixel defining layer may be 10% or less of the (1-1)th thickness, and the difference between the (1-1)th thickness and a (1-3)th thickness of a third portion of the first pixel defining layer not overlapping with the second pixel defining layer and the third pixel defining layer may be 10% or less of the (1-1)th thickness.

According to some embodiments, a fourth width of the third portion of the first pixel defining layer may be greater than or equal to 70 nm.

According to some embodiments, the second pixel defining layer and the third pixel defining layer may form an undercut structure.

According to some embodiments, a sum of a second thickness of the second pixel defining layer and a third thickness of the third pixel defining layer may be 1000 angstroms or less.

According to some embodiments, a fifth width of the second portion of the first pixel defining layer may be less than a sixth width of a lower surface of the third pixel defining layer not in contact with the second pixel defining layer.

According to some embodiments, the sixth width may be at least 1.5 times and no more than 2.5 times the second thickness.

According to some embodiments, the first pixel defining layer and the third pixel defining layer may each include silicon oxide, and the second pixel defining layer may include silicon nitride.

According to some embodiments, the second pixel defining layer may include: a (2-1)th pixel defining layer having a first film density, and a (2-2)th pixel defining layer on the (2-1)th pixel defining layer and having a second film density less than the first film density.

According to some embodiments, the (2-1)th pixel defining layer and the (2-2)th pixel defining layer may include a same material.

According to some embodiments, the third width may be equal to the first width.

According to some embodiments, a portion of the first pixel defining layer not overlapping with the second pixel defining layer and the third pixel defining layer may have a step difference.

According to one or more embodiments of the present disclosure, a display device includes: a first anode and a second anode spaced apart from the first anode, and a pixel defining layer on the first anode and the second anode and including openings exposing portions of the first anode and the second anode, respectively. According to some embodiments, the pixel defining layer comprises: a first pixel defining layer having a first taper angle and a first width, and a second pixel defining layer on the first pixel defining layer and having a second taper angle and a second width greater than the first width, and wherein each of the first taper angle and the second taper angle is an acute angle.

According to some embodiments, the first pixel defining layer and the second pixel defining layer may form an undercut structure.

According to some embodiments, a sum of a first thickness of the first pixel defining layer and a second thickness of the second pixel defining layer may be 1000 angstroms or less.

According to some embodiments, a third width of a lower surface of the second pixel defining layer not in contact with the first pixel defining layer may be at least 1.5 times and no more than 2.5 times the first thickness.

According to some embodiments, the first pixel defining layer may include silicon nitride, and the second pixel defining layer may include silicon oxide.

According to one or more embodiments of the present disclosure, an electronic device includes: a processor providing an image data signal, and a display device displaying an image based on the image data signal. According to some embodiments, the display device comprises: a first anode and a second anode spaced apart from the first anode, and a pixel defining layer on the first anode and the second anode and including openings exposing portions of the first anode and the second anode, respectively. According to some embodiments, the pixel defining layer comprises: a first pixel defining layer having a first taper angle and a first width, a second pixel defining layer on the first pixel defining layer and having a second taper angle and a second width less than the first width, and a third pixel defining layer on the second pixel defining layer and having a third taper angle and a third width, and wherein each of the first taper angle, the second taper angle, and the third taper angle is an acute angle.

According to some embodiments, the second pixel defining layer and the third pixel defining layer may form an undercut structure.

At least some of the above and other features of the invention are set out in the claims.

### BRIEF DESCRIPTION OF THE DRAWINGS

The above and other aspects and features of the present disclosure will be more clearly understood from the following detailed description of the illustrative, non-limiting embodiments with reference to the accompanying drawings.
FIG. 1 is schematically illustrates a display device according to some embodiments.
FIG. 2 schematically illustrates a sub-pixel according to some embodiments.
FIG. 3 schematically illustrates a display panel according to some embodiments.
FIG. 4 schematically illustrates a pixel according to some embodiments.
FIG. 5 is a cross-sectional view taken along the line I-I' of FIG. 4 according to some embodiments.
FIGS. 6 to 9 schematically illustrate manufacturing processes of a pixel defining layer of FIG. 5.
FIG. 10 is a cross-sectional view taken along the line I-I' of FIG. 4 according to some embodiments.
FIG. 11 is a cross-sectional view taken along the line I-I' of FIG. 4 according to some embodiments.
FIG. 12 is a cross-sectional view taken along the line I-I' of FIG. 4 according to some embodiments.
FIG. 13 is a cross-sectional view taken along the line I-I' of FIG. 4 according to some embodiments.
FIG. 14 is a cross-sectional view taken along the line I-I' of FIG. 4 according to some embodiments.
FIG. 15 is a cross-sectional view taken along the line II-II' of FIG. 4 according to some embodiments.
FIG. 16 is a diagram illustrating an electronic device according to some embodiments.
FIG. 17 shows schematic views of various embodiments of an electronic device according to some embodiments.

### DETAILED DESCRIPTION

Hereinafter, embodiments will be described in more detail with reference to the accompanying drawings, in which like reference numbers refer to like elements throughout. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art. Accordingly, processes, elements, and techniques that are not necessary to those having ordinary skill in the art for a complete understanding of the aspects and features of the present disclosure may not be described. Unless otherwise noted, like reference numerals denote like elements throughout the attached drawings and the written description, and thus, redundant description thereof may not be repeated.

When a certain embodiment may be implemented differently, a specific process order may be different from the described order. For example, two consecutively described processes may be performed at the same or substantially at the same time, or may be performed in an order opposite to the described order.

Further, as would be understood by a person having ordinary skill in the art, in view of the present disclosure in its entirety, each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner, unless otherwise stated or implied.

In the drawings, the relative sizes, thicknesses, and ratios of elements, layers, and regions may be exaggerated and/or simplified for clarity. Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly.

Further, it should be expected that the shapes shown in the figures may vary in practice depending, for example, on tolerances and/or manufacturing techniques. Accordingly, the embodiments of the present disclosure should not be construed as being limited to the specific shapes shown in the figures, and should be construed considering changes in shapes that may occur, for example, as a result of manufacturing. As such, the shapes shown in the drawings may not depict the actual shapes of areas of the device, and embodiments according to the present disclosure are not limited thereto.

In the figures, the DR1-axis, the DR2-axis, and the DR3-axis are not limited to three axes of the rectangular coordinate system, and may be interpreted in a broader sense. For example, the DR1-axis, the DR2-axis, and the DR3-axis may be perpendicular to or substantially perpendicular to one another, or may represent different directions from each other that are not perpendicular to one another.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present disclosure.

It will be understood that when an element or layer is referred to as being "on," "connected to," or "coupled to" another element or layer, it can be directly on, connected to, or coupled to the other element or layer, or one or more intervening elements or layers may be present. Similarly, when a layer, an area, or an element is referred to as being "electrically connected" to another layer, area, or element, it may be directly electrically connected to the other layer, area, or element, and/or may be indirectly electrically connected with one or more intervening layers, areas, or elements therebetween. In addition, it will also be understood that when an element or layer is referred to as being "between" two elements or layers, it can be the only element or layer between the two elements or layers, or one or more intervening elements or layers may also be present.

The terminology used herein is for the purpose of describing particular embodiments and is not intended to be limiting of the present disclosure. As used herein, the singular forms "a" and "an" are intended to include the plural forms as well, unless the context clearly indicates otherwise. It will be further understood that the terms "comprises," "comprising," "includes," "including," "has," "have," and "having," when used in this specification, specify the presence of the stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. For example, the expression "A and/or B" denotes A, B, or A and B. Expressions such as "at least one of," when preceding a list of elements, modify the entire list of elements and do not modify the individual elements of the list. For example, the expression "at least one of a, b, or c," "at least one of a, b, and c," and "at least one selected from the group consisting of a, b, and c" indicates only a, only b, only c, both a and b, both a and c, both b and c, all of a, b, and c, or variations thereof.

As used herein, the term "substantially," "about," and similar terms are used as terms of approximation and not as terms of degree, and are intended to account for the inherent variations in measured or calculated values that would be recognized by those of ordinary skill in the art. Further, the use of "may" when describing embodiments of the present disclosure refers to "one or more embodiments of the present disclosure." As used herein, the terms "use," "using," and "used" may be considered synonymous with the terms "utilize," "utilizing," and "utilized," respectively.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

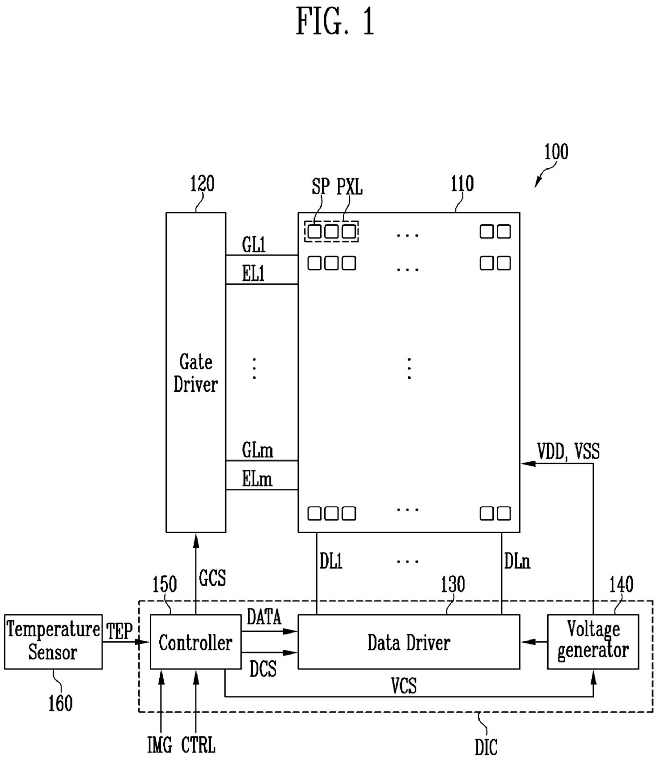

FIG. 1 schematically illustrates a display device according to some embodiments.

Referring to FIG. 1, the display device 100 may include a display panel 110, a gate driver 120, a data driver 130, a voltage generator 140, and a controller 150.

The display panel 110 may include sub-pixels SP. The sub-pixels SP may be connected to the gate driver 120 through first to mth gate lines GL1 to GLm. The sub-pixels SP may be connected to the data driver 130 through first to nth data lines DL1 to DLn.

Each of the sub-pixels SP may include at least one light-emitting element configured to generate light. Accordingly, each of the sub-pixels SP may generate light of a particular color, such as red, green, blue, cyan, magenta, yellow, or the like. Two or more of the sub-pixels SP may include a single pixel PXL. For example, as shown in FIG. 1, three sub-pixels may constitute the single pixel PXL.

The gate driver 120 may be connected to the sub-pixels SP arranged in a row direction through the first to the mth gate lines GL1 to GLm. The gate driver 120 may output gate signals to the first to mth gate lines GL1 to GLm in response to a gate control signal GCS. The gate control signal GCS may include a start signal to indicate the start of each frame, a horizontal synchronization signal to output gate signals in synchronization with the timing of data signals being applied, and the like.

First to mth emission control lines EL1 to ELm connected to sub-pixels SP may be further provided in the row direction. The gate driver 120 may include an emission control driver configured to control the first to mth light emission control lines EL1 to ELm, and the emission control driver may operate under the control of the controller 150.

The gate driver 120 may be arranged on one side of the display panel 110. However, embodiments according to the present disclosure are not necessarily limited thereto. For example, the gate driver 120 may be separated into two or more physically and/or logically distinct drivers, and such drivers may be arranged on one side of the display panel 110 and on the other side of the display panel 110 opposite the one side. As such, the gate driver 120 may be arranged in various configurations around the display panel 110 according to some embodiments.

The data driver 130 may be connected to the sub-pixels SP arranged in a column direction through the first to nth data lines DL1 to DLn. The data driver 130 may receive image data DATA and a data control signal DCS from the controller 150. The data driver 130 may operate in response to the data control signal DCS. The data control signal DCS may include a source start pulse, a source shift clock, a source output enable signal, and the like.

By using voltages from the voltage generator 140, the data driver 130 may apply data signals with grayscale voltages corresponding to the image data DATA to the first to nth data lines DL1 to DLn. When a gate signal is applied to each of the first to mth gate lines GL1 to GLm, data signals corresponding to the image data DATA may be applied to the first to nth data lines DL1 to DLn. Accordingly, the corresponding sub-pixels SP may generate light corresponding to the data signals. Accordingly, images may be displayed on the display panel 110.

The gate driver 120 and the data driver 130 may include complementary metal-oxide semiconductor (CMOS) circuit elements.

The voltage generator 140 may operate in response to a voltage control signal VCS from the controller 150. The voltage generator 140 may generate a plurality of voltages and provide the generated voltages to components of the display device 100. For example, the voltage generator 140 may receive an input voltage from outside the display device 100, control the received voltage, and regulate the controlled voltage to thereby generate the plurality of voltages.

The voltage generator 140 may generate a first power supply voltage VDD and a second power supply voltage VSS, and the generated first and second power supply voltages VDD and VSS may be provided to the sub-pixels SP. The first power supply voltage VDD may have a relatively high voltage level, and the second power supply voltage VSS may have a lower voltage level than the first power supply voltage VDD. However, embodiments according to the present disclosure are not necessarily limited thereto. For example, the first power supply voltage VDD or the second power supply voltage VSS may be provided by an external device of the display device 100.

In addition, the voltage generator 140 may generate various voltages. For example, the voltage generator 140 may generate an initialization voltage which is applied to the sub-pixels SP. For example, a reference voltage (e.g., a set or predetermined reference) voltage may be applied to the first to nth data lines DL1 to DLn during a sensing operation to sense the electrical characteristics of transistors and/or light-emitting elements of the sub-pixels SP, and the voltage generator 140 may generate the reference voltage.

The controller 150 may control various operations of the display device 100. The controller 150 may receive a control signal CTRL from an external source to control input image data IMG and the display thereof. The controller 150 may provide the gate control signal GCS, the data control signal DCS, and the voltage control signal VCS in response to the control signal CTRL.

The controller 150 may convert the input image data IMG so that the data may be suitable for the display device 100 or the display panel 110, and may output the image data DATA. The controller 150 may rearrange the input image data IMG to suit the sub-pixels SP in rows and output the image data DATA.

Two or more components among the data driver 130, the voltage generator 140, and the controller 150 may be mounted on a single integrated circuit. As shown in FIG. 1, the data driver 130, the voltage generator 140, and the controller 150 may be included in a driver integrated circuit DIC. The data driver 130, the voltage generator 140, and the controller 150 may be functionally distinct components in the single driver integrated circuit DIC. However, embodiments according to the present disclosure are not necessarily limited thereto. For example, at least one of the data driver 130, the voltage generator 140, or the controller 150 may be provided as a separate component from the driver integrated circuit DIC.

The display device 100 may include at least one temperature sensor 160. The temperature sensor 160 may sense the ambient temperature and generate temperature data TEP indicating the sensed temperature. The temperature sensor 160 may be arranged adjacent to the display panel 110 and/or the driver integrated circuit DIC.

The controller 150 may control various operations of the display device 100 in response to the temperature data TEP. The controller 150 may adjust the brightness of an image which is output from the display panel 110 in response to the temperature data TEP. For example, the controller 150 may control data signals and the first and second power supply voltages VDD and VSS by controlling components such as the data driver 130 and/or the voltage generator 140.

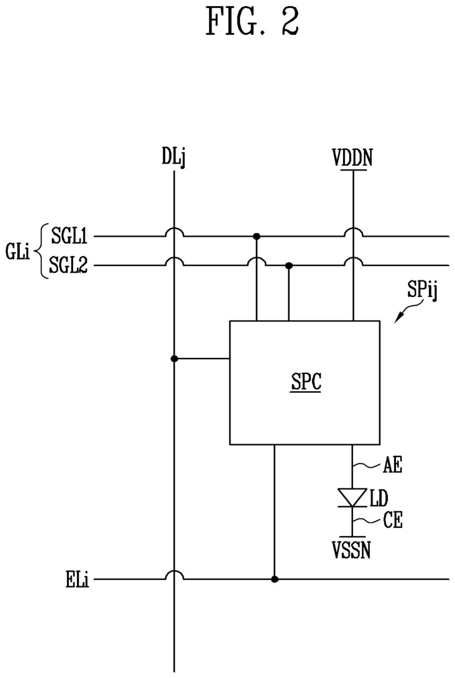

FIG. 2 schematically illustrates a sub-pixel according to some embodiments.

In FIG. 2, a sub-pixel SPij arranged in an ith row (where i is an integer greater than or equal to 1 and less than or equal to m) and a jth column (where j is an integer greater than or equal to 1 and less than or equal to n) is illustrated as an example.

Referring to FIG. 2, the sub-pixel SPij may include a sub-pixel circuit SPC and a light-emitting element LD.

The light-emitting element LD may be connected between a first power supply voltage node VDDN and a second power supply voltage node VSSN. The first power supply voltage node VDDN transfers the first power supply voltage VDD in FIG. 1, and the second power supply voltage node VSSN transfers the second power supply voltage VSS in FIG. 1.

An anode AE of the light-emitting element LD may be connected to the first power supply voltage node VDDN through the sub-pixel circuit SPC, and a cathode CE of the light-emitting element LD may be connected to the second power supply voltage node VSSN. For example, the anode AE of the light-emitting element LD may be connected to the first power supply voltage node VDDN through one or more transistors included in the sub-pixel circuit SPC.

The sub-pixel circuit SPC may be connected to an ith gate line GLi of the first to mth gate lines GL1 to GLm of FIG. 1, an ith emission control line ELi of the first to mth emission control lines EL1 to ELm of FIG. 1, and a jth data line DLj of the first to nth data lines DL1 to DLn of FIG. 1. The sub-pixel circuit SPC may control the light-emitting element LD according to signals received through these signal lines.

The sub-pixel circuit SPC may operate in response to a gate signal received through the ith gate line GLi. The ith gate line GLi may include one or more sub-gate lines. As shown in FIG. 2, the ith gate line GLi may include first and second sub-gate lines SGL1 and SGL2. The subpixel circuit SPC may operate in response to gate signals received through the first and second sub gate lines SGL1 and SGL2. As such, when the ith gate line GLi includes two or more sub-gate lines, the sub-pixel circuit SPC may operate in response to gate signals received through these sub-gate lines.

The sub-pixel circuit SPC may operate in response to an emission control signal received through the ith emission control line ELi. The ith emission control line ELi may include one or more sub-emission control lines. When the ith emission control line ELi includes two or more sub-emission control lines, the sub-pixel circuit SPC may operate in response to emission control signals received through the corresponding sub-emission control lines.

The sub-pixel circuit SPC may receive a data signal through the jth data line DLj. The sub-pixel circuit SPC may store a voltage corresponding to the data signal in response to at least one of the gate signals received through the first or second sub-gate lines SGL1 or SGL2. In response to an emission control signal received through the ith emission control line ELi, the sub-pixel circuit SPC may control a current flowing from the first power supply voltage node VDDN to the second power supply voltage node VSSN through the light-emitting element LD according to the stored voltage. Accordingly, the light-emitting element LD may generate light of a luminance corresponding to the data signal.

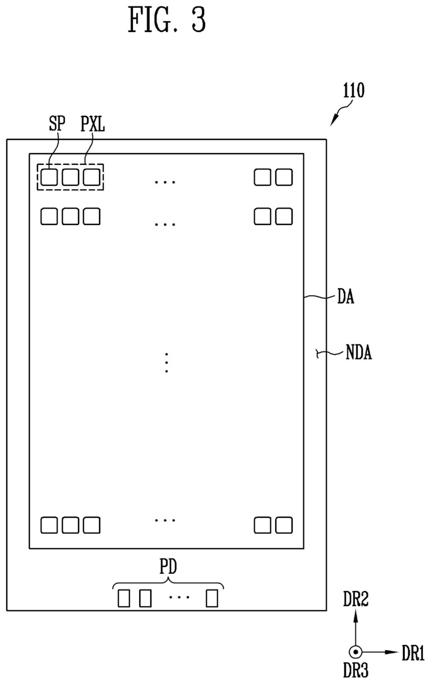

FIG. 3 schematically illustrates the display panel according to some embodiments.

Referring to FIG. 3, the display panel 110 may include a display area DA and a non-display area NDA. The display panel 110 may display images through the display area DA. The non-display area NDA may be arranged around (e.g., in a periphery or outside a footprint of) the display area DA.

The display panel 110 may include sub-pixels SP and pads PD.

The sub-pixels SP may be arranged in the display area DA. The sub-pixels SP may be arranged in a matrix format in a first direction DR1 and a second direction DR2 crossing the first direction DR1. However, embodiments according to the present disclosure are not necessarily limited thereto. For example, the sub-pixels SP may be arranged in a zigzag pattern in the first direction DR1 and the second direction DR2. For example, the sub-pixels SP may be arranged in PenTile^{™} shape. The first direction DR1 may be a row direction and the second direction DR2 may be a column direction.

Two or more sub-pixels among the plurality of sub-pixels SP may form a single pixel PXL.

Components for controlling the sub-pixels SP may be arranged in the non-display area NDA. For example, wiring connected to the sub-pixels SP, such as the first to mth gate lines GL1 to GLm and the first to nth data lines DL1 to DLn in FIG. 1, may be arranged in the non-display area NDA.

At least one of the gate driver 120, the data driver 130, the voltage generator 140, the controller 150, or the temperature sensor 160 of FIG. 1 may be integrated in the non-display area NDA of the display panel 110. The gate driver 120 of FIG. 1 may be mounted on the display panel 110 and arranged in the non-display area NDA. However, embodiments according to the present disclosure are not necessarily limited thereto. For example, the gate driver 120 may be implemented as an integrated circuit separate from the display panel 110. The temperature sensor 160 may be arranged in the non-display area NDA to sense the temperature of the display panel 110.

The pads PD may be located in the non-display area NDA. The pads PD may be electrically connected to the sub-pixels SP through the wiring. For example, the pads PD may be connected to the sub-pixels SP through the first to nth data lines DL1 to DLn as shown in FIG. 1.

The pads PD may interface the display panel 110 to other components of the display device 100 as shown in FIG. 1. The voltages and signals required for operations of the components included in the display panel 110 may be provided through the pads PD from the driver integrated circuit DIC of FIG. 1. For example, the first to nth data lines DL1 to DLn may be connected to the driver integrated circuit DIC through the pads PD. For example, the first and second power supply voltages VDD and VSS may be received from the driver integrated circuit DIC through the pads PD. For example, when the gate driver 120 is mounted on the display panel 110, the gate control signal GCS may be transferred to the gate driver 120 through the pads PD from the driver integrated circuit DIC.

A circuit board may be electrically connected to the pads PD through a conductive adhesive member, such as an anisotropic conductive film. The circuit board may be a flexible printed circuit board (FPCB) or a flexible film having a flexible material. The driver integrated circuit DIC may be mounted on the circuit board and electrically connected to the pads PD.

The display area DA may have various shapes. The display area DA may have the shape of a closed loop which includes straight and/or curved sides. For example, the display area DA may have the shape of a polygon, a circle, a semicircle, an ellipse, an irregular shape or the like.

The display panel 110 may have a flat display surface. However, embodiments according to the present disclosure are not necessarily limited thereto. For example, the display panel 110 may have a display surface which is at least partially rounded. The display panel 110 may be bendable, foldable, or rollable. The display panel 110 may include materials having flexible properties.

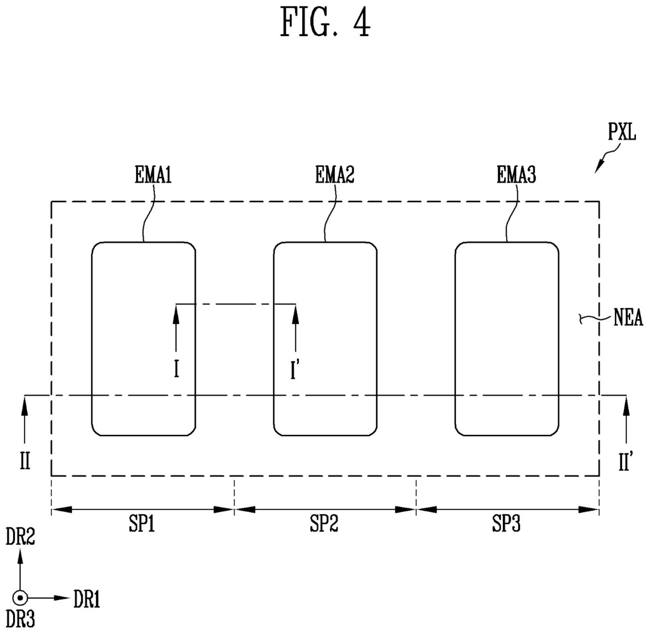

FIG. 4 schematically illustrates the pixel according to some embodiments.

Referring to FIG. 4, the pixel PXL may include first to third sub-pixel SP1 to SP3 arranged in the first direction DR1.

The first sub-pixel SP1 may include a first emission area EMA1 and a non-emission area NEA around the first emission area EMA1. The first sub-pixel SP1 may generate red-colored light. The second sub-pixel SP2 may include a second emission area EMA2 and the non-emission area NEA around the second emission area EMA2. The second sub-pixel SP2 may generate green-colored light. The third sub-pixel SP3 may include a third emission area EMA3 and the non-emission area NEA around the third emission area EMA3. The third sub-pixel SP3 may generate light in a blue color.

The arrangement of the sub-pixels shown in FIG. 4 is shown as an example, and embodiments according to the present disclosure are not necessarily limited thereto. Each pixel may include two or more sub-pixels, the sub-pixels may be arranged in various ways, each of the sub-pixels may have various shapes, and light emitting regions thereof may have various shapes.

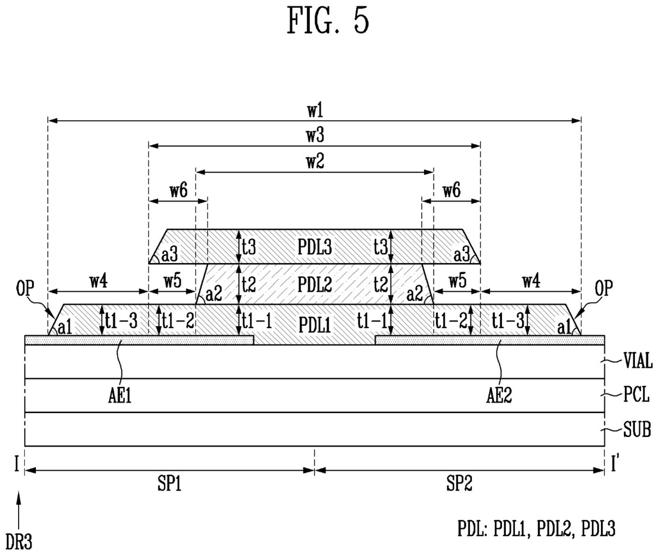

FIG. 5 is a cross-sectional diagram taken along the line I-I' of FIG. 4 according to some embodiments.

Referring to FIG. 5, a substrate SUB may be a silicon wafer substrate formed using a semiconductor process. For example, the substrate SUB may include silicon, germanium, and/or silicon-germanium. However, embodiments according to the present disclosure are not necessarily limited thereto. For example, the substrate SUB may be a glass substrate or a polyimide (PI) substrate.

The pixel circuit layer PCL may be arranged on the substrate SUB. The pixel circuit layer PCL may include circuit elements of both first and second sub-pixels SP1 and SP2. For example, the pixel circuit layer PCL may include transistors and one or more capacitors included in the sub-pixel circuit SPC (see FIG. 2) of the first sub-pixel SP1 and transistors and one or more capacitors included in the sub-pixel circuit SPC of the second sub-pixel SP2.

A via layer VIAL may be arranged on the pixel circuit layer PCL. The via layer VIAL may planarize step differences on the pixel circuit layer PCL. For example, the via layer VIAL may cover the pixel circuit layer PCL and have a generally flat surface. The via layer VIAL may include at least one of, but are not necessarily limited to, silicon oxide (SiOₓ), silicon nitride (SiNₓ), or silicon carbon nitride (SiCN).

First and second anodes AE1 and AE2 may be spaced apart from each other on the via layer VIAL. The first anode AE1 may be included in the first sub-pixel SP1, and the second anode AE2 may be included in the second sub-pixel SP2. The first anode AE1 may be connected to the sub-pixel circuit SPC of the first sub-pixel SP1 included in the pixel circuit layer PCL through a contact hole passing through the via layer VIAL. The second anode AE2 may be connected to the sub-pixel circuit SPC of the second sub-pixel SP2 included in the pixel circuit layer PCL through a contact hole formed through the via layer VIAL. The first and second anodes AE1 and AE2 may include a transparent conductive material. For example, the first and second anodes AE1 and AE2 may include at least one of indium tin oxide (ITO), indium zinc oxide (IZO), zinc oxide (ZnO), indium gallium zinc oxide (IGZO), or indium tin zinc oxide (ITZO). The first and second anodes AE1 and AE2 may have a single-layer structure and a multilayer structure including any of the materials. However, embodiments according to the present disclosure are not necessarily limited thereto.

The pixel defining layer PDL may be arranged on the first and second anodes AE1 and AE2 and the via layer VIAL. The pixel defining layer PDL may include openings OP which partially expose the first and second anodes AE1 and AE2, respectively. The pixel defining layer PDL may have a multilayer structure. For example, the pixel defining layer PDL may include a first pixel defining layer PDL1, a second pixel defining layer PDL2, and a third pixel defining layer PDL3.

The first pixel defining layer PDL1 may be arranged on the first and second anodes AE1 and AE2 and on the via layer VIAL. The first pixel defining layer PDL1 may have a first width w1. The first width w1 may be a length between both ends of the first pixel defining layer PDL1. The first pixel defining layer PDL1 may include the openings OP as described above. The first pixel defining layer PDL1 may include silicon oxide (SiOₓ). The first pixel defining layer PDL1 may have a tapered (or trapezoidal) shape in cross-section. Hereinafter, the tapered shape may have a width decreasing gradually in a third direction DR3. A first taper angle a1 of the first pixel defining layer PDL1 may be an acute angle.

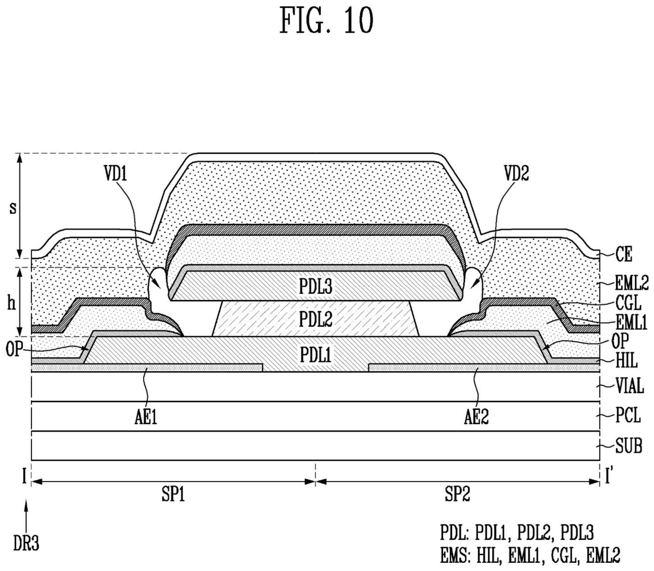

The first pixel defining layer PDL1 may be flat or planar (or generally flat or planar). A portion of the first pixel defining layer PDL1 which overlaps with the second pixel defining layer PDL2 and the third pixel defining layer PDL3 (hereinafter, a first portion of the first pixel defining layer PDL1) may have a (1-1)th thickness t1-1. A portion of the first pixel defining layer PDL1 which overlaps with the third pixel defining layer PDL3 and does not overlap with the second pixel defining layer PDL2 (hereinafter, a second portion of the first pixel defining layer PDL1) may have a (1-2)th thickness t1-2. A portion of the first pixel defining layer PDL1 which does not overlap with the second pixel defining layer PDL2 and the third pixel defining layer PDL3 (hereinafter, a third portion of the first pixel defining layer PDL1) may have a (1-3)th thickness t1-3. For example, the (1-1)th thickness t1-1, the (1-2)th thickness t1-2, and the (1-3)th thickness t1-3 as described above may be the same as each other. Since there is no step difference in the first pixel defining layer PDL1, a height h of first and second voids VD1 and VD2 as shown in FIG. 10 may be controlled by adjusting only a second thickness t2 of the second pixel defining layer PDL2. As a result, process control may be facilitated and quality fluctuations may be reduced, which may enable securing margins. However, embodiments according to the present disclosure are not necessarily limited thereto. For example, the (1-2)th thickness t1-2 and the (1-3)th thickness t1-3 may be smaller than the (1-1)th thickness t1-1. The difference between the (1-1)th thickness t1-1 and the (1-2)th thickness t1-2 may be 10% or less of the (1-1)th thickness t1-1. Similarly, the difference between the (1-1)th thickness t1-1 and the (1-3)th thickness t1-3 may be 10% or less of the (1-1)th thickness t1-1.

The third portion of the first pixel defining layer PDL1 may be generally flat. A fourth width w4 of the third portion of the first pixel defining layer PDL1 may be 70 nm or greater. The fourth width w4 may refer to a length between both ends of the third portion of the first pixel defining layer PDL1. When the flat third portion of the first pixel defining layer PDL1 is ensured sufficiently, a step difference s (see FIG. 10) of the cathode CE (see FIG. 10) may be relatively reduced. This will be described in more detail with reference to FIG. 10.

The second pixel defining layer PDL2 may be arranged on top of the first pixel defining layer PDL1. The second pixel defining layer PDL2 may have a second width w2 which is smaller than the first width w1. The second width w2 may be a length between both ends of the second pixel defining layer PDL2. The second pixel defining layer PDL2 may partially overlap with the first and second anodes AE1 and AE2. The second pixel defining layer PDL2 may include silicon nitride (SiNₓ). The second pixel defining layer PDL2 may have a tapered (or trapezoidal) shape in cross-section. A second taper angle a2 of the second pixel defining layer PDL2 may be an acute angle.

The third pixel defining layer PDL3 may be arranged on top of the second pixel defining layer PDL2. The third pixel defining layer PDL3 may have a third width w3 which is smaller than the first width w1 and larger than the second width w2. The third width w3 may be a length between both ends of the third pixel defining layer PDL3. The third pixel defining layer PDL3 may include silicon oxide (SiOₓ). The third pixel defining layer PDL3 may have a tapered shape (or a trapezoidal shape) in cross-section. A third taper angle a3 of the third pixel defining layer PDL3 may be an acute angle. The first, second, and third taper angles a1, a2, and a3 may be acute angles, and the interrelationship therebetween is not particularly limited.

The second pixel defining layer PDL2 and the third pixel defining layer PDL3 may form an undercut structure. For example, the second pixel defining layer PDL2 may have an inwardly recessed structure relative to the third pixel defining layer PDL3. For example, the third pixel defining layer PDL3 may have an outwardly protruding structure compared to the second pixel defining layer PDL2. The sum of the second thickness t2 of the second pixel defining layer PDL2 and the third thickness t3 of the third pixel defining layer PDL3 may be 1000 angstroms or less. A sixth width w6 of a lower surface of the protruding portion of the third pixel defining layer PDL3 may be at least 1.5 times and no more than (e.g., less than or equal to) 2.5 times the second thickness t2. A protruding portion of the third pixel defining layer PDL3 may be a lower surface of the third pixel defining layer PDL3 which is not in contact with the second pixel defining layer PDL2. The sixth width w6 may be a length between an end of an upper surface of the second pixel defining layer PDL2 and an end of the third pixel defining layer PDL3. The second pixel defining layer PDL2 may gradually narrow in the third direction DR3 such that the sixth width w6 may be greater than a fifth width w5 of the second portion of the first pixel defining layer PDL1. The above-described undercut structure described may block leakage current between the first and second sub-pixels SP1 and SP2, which will be described below with reference to FIG. 10.

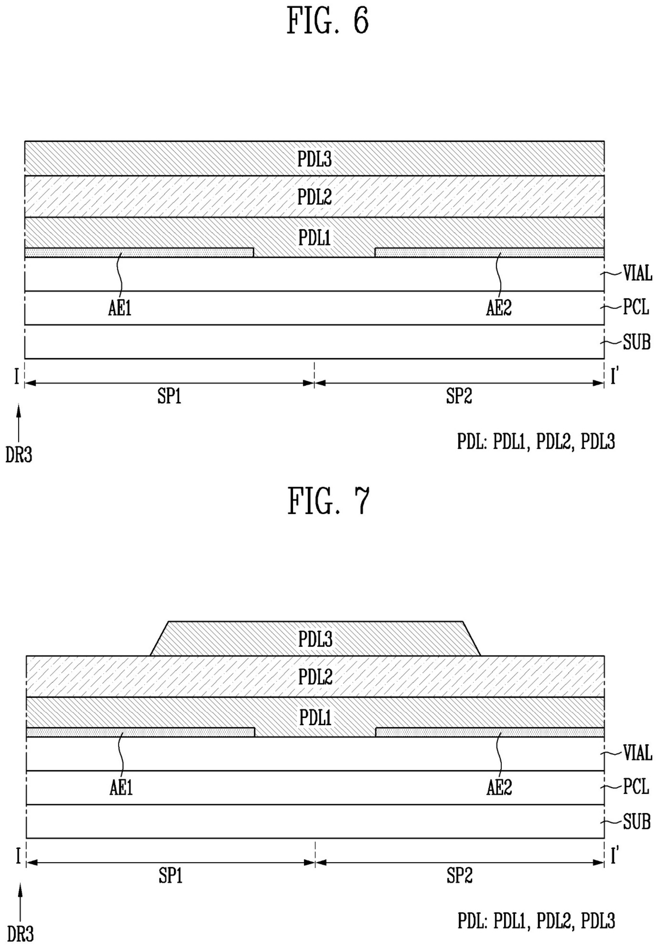

FIGS. 6 to 9 schematically illustrate manufacturing processes of the pixel defining layer of FIG. 5.

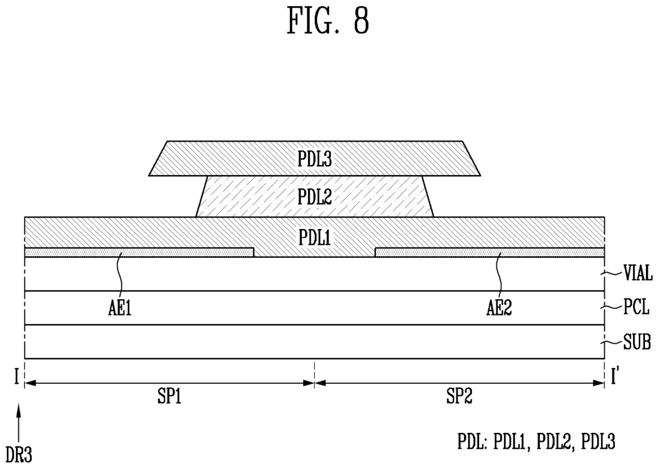

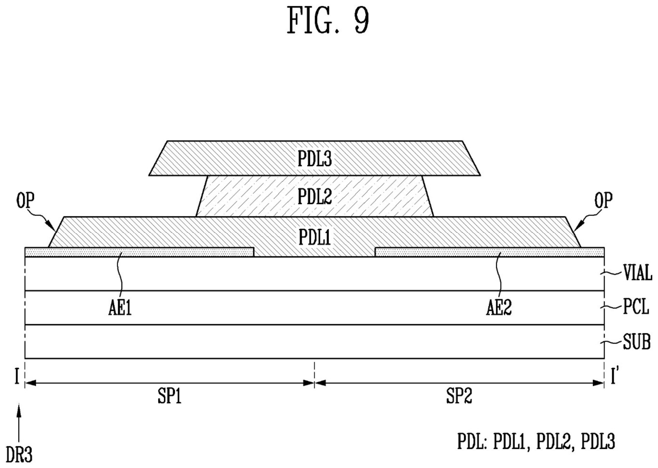

Referring to FIG. 6, the first pixel defining layer PDL1, the second pixel defining layer PDL2, and the third pixel defining layer PDL3 may be formed sequentially on the first and second anodes AE1 and AE2 and the via layer VIAL. Referring to FIG. 7, a portion of the third pixel defining layer PDL3 may be removed by a dry etching process to form the third pixel defining layer PDL3 having a tapered shape. Referring to FIG. 8, a portion of the second pixel defining layer PDL2 may be removed by a wet etching process to form the second pixel defining layer PDL2 having an inwardly recessed structure and a tapered shape compared to the third pixel defining layer PDL3. Accordingly, the second pixel defining layer PDL2 and the third pixel defining layer PDL3 having the undercut structure may be formed. Referring to FIG. 9, a portion of the first pixel defining layer PDL1 may be removed by a dry etching process to form the openings OP exposing portions of the first and second anodes AE1 and AE2, respectively.

FIG. 10 is a cross-sectional diagram taken along the line I-I' of FIG. 4 according to some embodiments. In FIG. 10, the description about the overlapping contents with FIG. 5 is shortened or omitted.

Referring to FIG. 10, an emission structure EMS may be arranged on the first and second anodes AE1 and AE2 and the pixel defining layer PDL. The emission structure EMS may include, but is not necessarily limited to, a hole injection layer HIL, a first light-emitting layer EML1, a charge generation layer CGL, and a second light-emitting layer EML2. For example, the emission structure EMS may further include at least one electron transport layer. As shown in FIG. 10, the emission structure EMS may have a 2 stack tandem structure, but embodiments according to the present disclosure are not necessarily limited thereto. For example, the emission structure EMS may have a tandem structure including three or more stacks including at least three light emitting layers and at least two charge generation layers.

The hole injection layer HIL may be arranged entirely on the first and second anodes AE1 and AE2. The hole injection layer HIL may be partially arranged on the first pixel defining layer PDL1. For example, due to the undercut structure, the hole injection layer HIL may not be deposited on the first pixel defining layer PDL1 near the second pixel defining layer PDL2. The hole injection layer HIL may be arranged entirely on the third pixel defining layer PDL3. As shown in FIG. 10, the hole injection layer HIL may be disconnected due to the undercut structure. Thus, the leakage current between the first and second sub-pixels SP1 and SP2 through the hole injection layer HIL may be blocked to prevent or reduce image quality degradation due to coloration, luminance degradation, etc.

The first light-emitting layer EML1 may be arranged on the hole injection layer HIL. The charge generation layer CGL may be arranged on the first light-emitting layer EML1. Due to the undercut structure, the first and second voids VD1 and VD2 may be formed during the deposition of the hole injection layer HIL, the first light-emitting layer EML1, and the charge generation layer CGL. As shown in FIG. 10, the charge generation layer CGL may be disconnected by the first and second voids VD1 and VD2. Thus, the leakage current between the first and second sub-pixels SP1 and SP2 through the charge generation layer CGL may be blocked, thereby preventing or reducing image quality degradation due to coloration, luminance degradation, etc.

The second light-emitting layer EML2 may be arranged entirely on the charge generation layer CGL and the first and second voids VD1 and VD2. For example, the second light-emitting layer EML2 may be deposited continuously without being disconnected. The cathode CE may be arranged entirely on the second light-emitting layer EML2. For example, the cathode CE may be deposited continuously without being disconnected. As shown in FIG. 10, the cathode CE may be deposited unevenly by the first and second voids VD1 and VD2, resulting in the step difference s. The step difference s of the cathode CE may vary depending on the height h of the first and second voids VD1 and VD2. For example, the larger the height h of the first and second voids VD1 and VD2, the larger the step difference s of the cathode CE may be. The height h of the first and second voids VD1 and VD2 may vary depending on the third portion of the third pixel defining layer PDL3. For example, the height h of the first and second voids VD1 and VD2 may increase when the third portion of the third pixel defining layer PDL3 is not flat but is depressed. As shown in FIG. 10, the growth of the first and second voids VD1 and VD2 may be inhibited by the flatness of the third portion of the first pixel defining layer PDL1, which may reduce the height h of the first and second voids VD1 and VD2, and consequently, the step difference s of the cathode CE may be reduced. Reducing the step difference s of the cathode CE may reduce an IR drop, which may increase power efficiency.

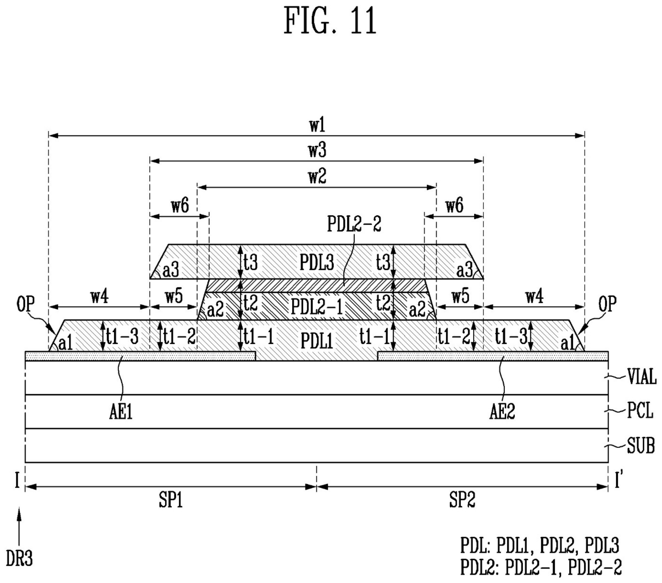

FIG. 11 is a cross-sectional diagram taken along the line I-I' of FIG. 4 according to some embodiments. In FIG. 11, overlapping contents with FIG. 5 are simplified or omitted.

Referring to FIG. 11, the second pixel defining layer PDL2 may have a multilayer structure. For example, the second pixel defining layer PDL2 may include a (2-1)th pixel defining layer PDL2-1 and a (2-2)th pixel defining layer PDL2-2.

The (2-1)th pixel defining layer PDL2-1 may be arranged on the first pixel defining layer PDL1. The (2-1)th pixel defining layer PDL2-1 may include silicon nitride (SiNₓ). The (2-1)th pixel defining layer PDL2-1 may have a first film density.

The (2-2)th pixel defining layer PDL2-2 may be arranged on the (2-1)th pixel defining layer PDL2-1. The (2-2)th pixel defining layer PDL2-2 may include silicon nitride (SiNₓ). The (2-1)th pixel defining layer PDL2-1 may have a second film density which is smaller than the first film density.

Due to the difference between the first film density of the (2-1)th pixel defining layer PDL2-1 and the second film density of the (2-2)th pixel defining layer PDL2-2, an undercut structure (or a tapered shape of the second pixel defining layer PDL2) may be easily formed. For example, because the second film density of the (2-2)th pixel defining layer PDL2-2 is relatively small, an etch rate of the (2-2)th pixel defining layer PDL2-2 may be higher than an etch rate of the (2-1)th pixel defining layer PDL2-1 during a wet etch process, which may cause the (2-2)th pixel defining layer PDL2-2 to be etched more inwardly.

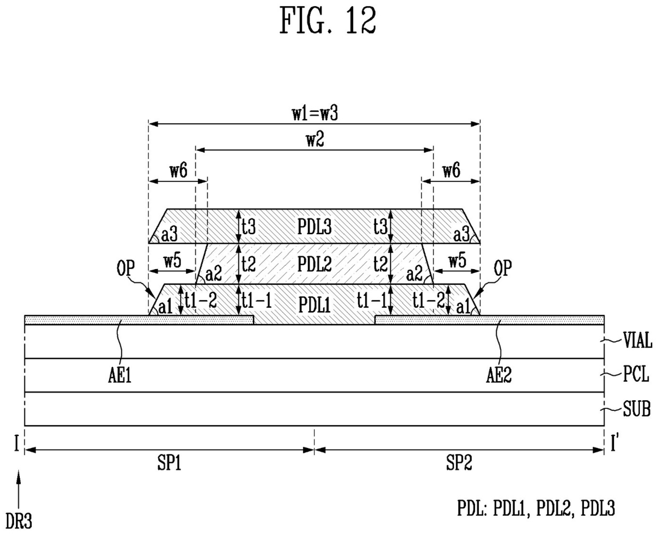

FIG. 12 is a cross-sectional diagram taken along the line I-I' of FIG. 4 according to some embodiments. In FIG. 12, overlapping contents with FIG. 5 are simplified or omitted.

Referring to FIG. 12, the first width w1 of the first pixel defining layer PDL1 may be equal to the third width w3 of the third pixel defining layer PDL3. The third portion of the first pixel defining layer PDL1 shown in FIG. 5 may be removed through a dry etch process.

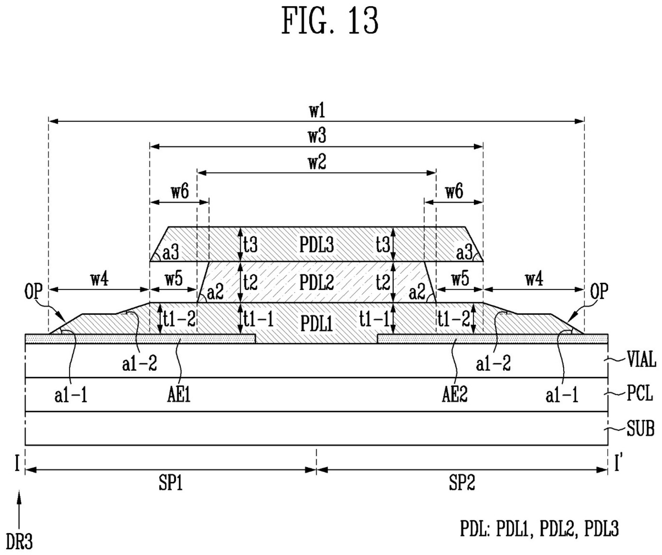

FIG. 13 is a cross-sectional diagram taken along the line I-I' of FIG. 4 according to some embodiments. In FIG. 13, overlapping contents with FIG. 5 are simplified or omitted.

Referring to FIG. 13, the third portion of the first pixel defining layer 1 PDL1 may be partially flat. For example, the third portion of the first pixel defining layer PDL1 may have a step difference. As a result, the first pixel defining layer PDL1 may have a (1-1)th taper angle a1-1 and a (1-2)th taper angle a1-2. The (1-1)th taper angle a1-1 and the (1-2)th taper angle a1-2 may be acute angles.

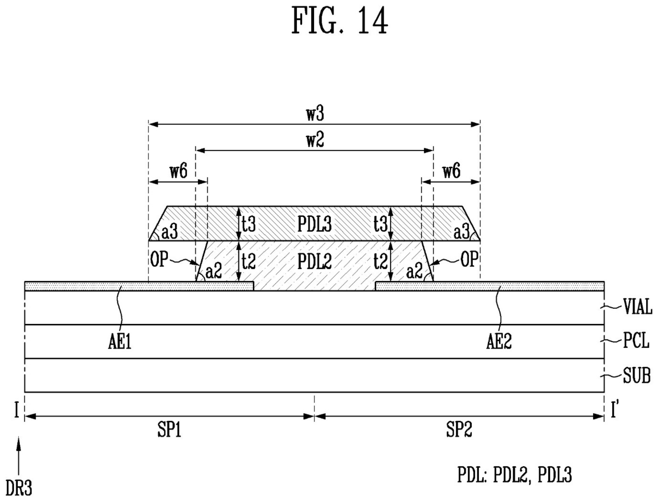

FIG. 14 is a cross-sectional diagram taken along the line I-I' of FIG. 4 according to some embodiments. In FIG. 14, overlapping contents with FIG. 5 are simplified or omitted.

Referring to FIG. 14, the pixel defining layer PDL may have a dual-layer structure including the second pixel defining layer PDL2 and the third pixel defining layer PDL3. In other words, the first pixel defining layer PDL1 of FIG. 5 may be omitted. The second pixel defining layer PDL2 may include the openings OP exposing the first and second anodes AE1 and AE2.

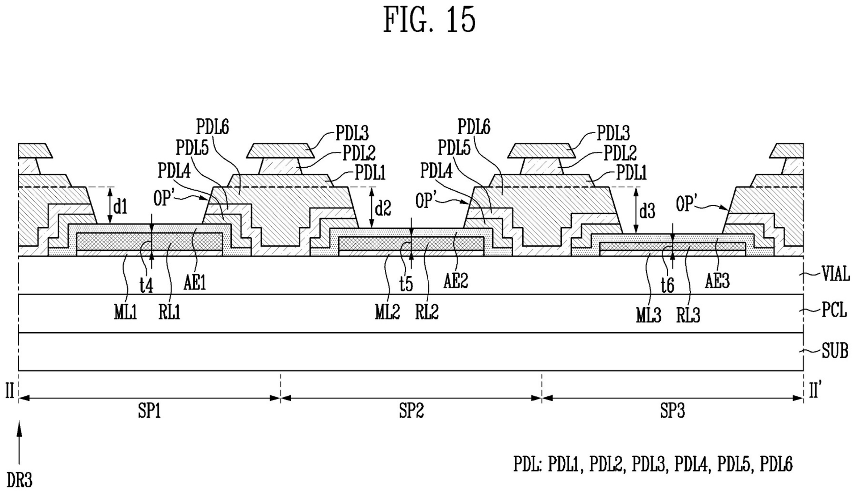

FIG. 15 is a cross-sectional view taken along the line II-II' of FIG. 4 according to some embodiments. In FIG. 15, overlapping contents with FIG. 5 are simplified or omitted.

Referring to FIG. 15, a first mirror layer ML1, a second mirror layer ML2, and a third mirror layer ML3 may be arranged on the via layer VIAL. The first, second, and third mirror layers ML1, ML2, and ML3 may be spaced apart from each other. The first mirror layer ML1 may be connected to the sub-pixel circuit SPC (see FIG. 2) of the first sub-pixel SP1 included in the pixel circuit layer PCL through the contact hole passing through the via layer VIAL. The second mirror layer ML2 may be connected to the sub-pixel circuit SPC of the second sub-pixel SP2 included in the pixel circuit layer PCL through the contact hole passing through the via layer VIAL. The third mirror layer ML3 may be connected to the sub-pixel circuit SPC of the third sub-pixel SP3 included in the pixel circuit layer PCL through the contact hole passing through the via layer VIAL. The first, second, and third mirror layers ML1, ML2, and ML3 may reflect light emitted by the first, second, and third sub-pixels SP1, SP2, and SP3, respectively, toward the surface (or in the third direction DR3). The first, second, and third mirror layers ML1, ML2, and ML3 may include at least one of aluminium (Al), silver (Ag), magnesium (Mg), platinum (Pt), palladium (Pd), gold (Au), nickel (Ni), neodymium (Nd), iridium (Ir), chromium (Cr), titanium (Ti), or an alloy of two or more materials selected therefrom. The first, second, and third mirror layers ML1, ML2, and ML3 may have a single-layer structure or a multilayer structure including the above-described materials. For example, the first, second, and third mirror layers ML1, ML2, and ML3 may have a dual-layer structure of aluminium/titanium (Al/Ti), but embodiments according to the present disclosure are not necessarily limited thereto.

A first resonant layer RL1 may be arranged on the first mirror layer ML1. A second resonant layer RL2 may be arranged on the second mirror layer ML2. A third resonant layer RL3 may be arranged on the third mirror layer ML3. The thickness of each of the first, second, and third resonant layers RL1, RL2, and RL3 may vary depending on the wavelength of each of the light emitted by the first, second, and third sub-pixels SP1, SP2, and SP3. For example, when the first sub-pixel SP1 emits red-colored light, the second sub-pixel SP2 emits green-colored light, and the third sub-pixel SP3 emits blue-colored light, a fifth thickness t5 of the second resonant layer RL2 may be smaller than a fourth thickness t4 of the first resonant layer RL1, and a sixth thickness t6 of the third resonant layer RL3 may be smaller than the fifth thickness t5 of the second resonant layer RL2. As a result, a resonance distance of the light emitted from the first, second, and third sub-pixels SP1, SP2, and SP3 may be adjusted, and the light emission efficiency may be relatively improved. The first, second, and third resonant layers RL1, RL2, and RL3 may include silicon oxide (SiOₓ), but embodiments according to the present disclosure are not necessarily limited thereto.

The first anode AE1 may be arranged on the first resonant layer RL1 and the via layer VIAL. The first anode AE1 may surround the first resonant layer RL1 and the first mirror layer ML1. The first anode AE1 may contact a side surface of the first mirror layer ML1. The first anode AE1 may be connected to the sub-pixel circuit SPC of the first sub-pixel SP1 included in the pixel circuit layer PCL through the first mirror layer ML1 and the contact hole connected to the first mirror layer ML1. The second anode AE2 may be arranged on the second resonant layer RL2 and the via layer VIAL. The second anode AE2 may surround the second resonant layer RL2 and the second mirror layer ML2. The second anode AE2 may contact the side surface of the second mirror layer ML2. The second anode AE2 may be connected to the sub-pixel circuit SPC of the second sub-pixel SP2 included in the pixel circuit layer PCL through the second mirror layer ML2 and the contact hole connected to the second mirror layer ML2. A third anode AE3 may be arranged on the third resonant layer RL3 and the via layer VIAL. The third anode AE3 may surround the third resonant layer RL3 and the third mirror layer ML3. The third anode AE3 may contact the side surface of the third mirror layer ML3. The third anode AE3 may be connected to the sub-pixel circuit SPC of the third sub-pixel SP3 included in the pixel circuit layer PCL through the contact hole connected to the third mirror layer ML3 and the third mirror layer ML3.

The pixel defining layer PDL may include the first pixel defining layer PDL1, the second pixel defining layer PDL2, the third pixel defining layer PDL3, a fourth pixel defining layer PDL4, a fifth pixel defining layer PDL5, and a sixth pixel defining layer PDL6. The first, second, and third pixel defining layers PDL1, PDL2, and PDL3 in FIG. 15 may be the same (or substantially the same) as the first, second, and third pixel defining layers PDL1, PDL2, and PDL3 in FIG. 5.

The fourth pixel defining layer PDL4 may be arranged on portions of the first anode AE1, the second anode AE2, and the third anode AE3. The fourth pixel defining layer PDL4 may include silicon oxide (SiOₓ).

The fifth pixel defining layer PDL5 may be arranged on the fourth pixel defining layer PDL4 and the via layer VIAL. Due to the difference in thickness of the first, second, and third resonant layers RL1, RL2, and RL3, the fifth pixel defining layer PDL5 may have a step difference. The fifth pixel defining layer PDL5 may include silicon nitride (SiNₓ).

The sixth pixel defining layer PDL6 may be arranged on the fifth pixel defining layer PDL5. The sixth pixel defining layer PDL6 may be generally flat and may eliminate the step difference formed in the fifth pixel defining layer PDL5. A first distance d1 between the first anode AE1 and the sixth pixel defining layer PDL6 may be smaller than a second distance d2 between the second anode AE2 and the sixth pixel defining layer PDL6. The second distance d2 between the second anode AE2 and the sixth pixel defining layer PDL6 may be smaller than a third distance d3 between the third anode AE3 and the sixth pixel defining layer PDL6. The first distance d1 may be a vertical distance between an upper surface of the first anode AE1 and an upper surface of the sixth pixel defining layer PDL6. The second distance d2 may be a vertical distance between an upper surface of the second anode AE2 and the upper surface of the sixth pixel defining layer PDL6. The third distance d3 may be a vertical distance between an upper surface of the third anode AE3 and the upper surface of the sixth pixel defining layer PDL6. The sixth pixel defining layer PDL6 may include silicon oxide (SiOₓ).

The fourth, fifth, and sixth pixel defining layers PDL4, PDL5, and PDL6 may include openings OP' exposing portions of the first anode AE1, the second anode AE2, and the third anode AE3, respectively.

The first, second, and third pixel defining layers PDL1, PDL2, and PDL3 as shown in FIG. 5 may be arranged on the sixth pixel defining layer PDL6. The flat upper surface of the sixth pixel defining layer PDL6 allows the first pixel defining layer PDL1 and the second and third pixel defining layers PDL2 and PDL3 forming an undercut structure to be stably arranged (or formed) on the sixth pixel defining layer PDL6.

The display device 100 as shown FIG. 1 may be applied to various electronic devices. The electronic device may include the display device 100 as described above, and may further include modules or devices having other additional functions in addition to the display device 100.

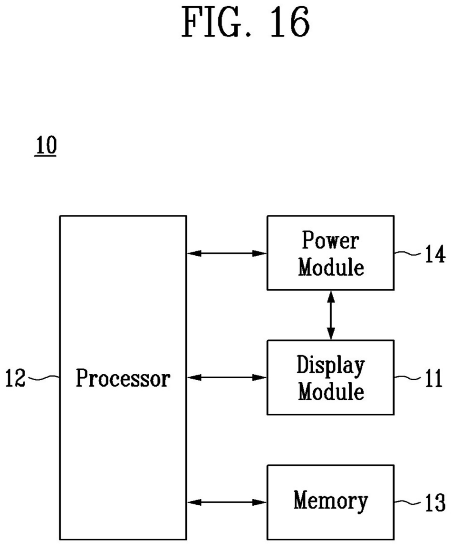

FIG. 16 is a block diagram of the electronic device according to some embodiments. Referring to FIG. 16, the electronic device 10 according to some embodiments may include a display module 11, a processor 12, a memory 13, and a power module 14.

The processor 12 may include at least one of a central processing unit (CPU), an application processor (AP), a graphic processing unit (GPU), a communication processor (CP), an image signal processor (ISP), or a controller.

The memory 13 may store data and/or information used to operate the processor 12 or the display module 11. When the processor 12 executes an application stored in the memory 13, image data signals and/or input control signals may be transferred to the display module 11. The display module 11 may process the provided signals and output image information on a display screen.

The power module 14 may include a power supply module, such as a power adapter or a battery device, and a power conversion module. The power conversion module converts power supplied by the power supply module and generates power to operate the electronic device 10.

At least one of the above-described components of the electronic device 10 may be included in the display device according to the above-described embodiments. In addition, in terms of functionality, some of the individual modules included in one module may be included in the display device and others may be provided separately from the display device. For example, the display module 11 is included in the display device, whereas the processor 12, the memory 13, and the power module 14 are not included in the display device and are instead provided separately in the electronic device 10.

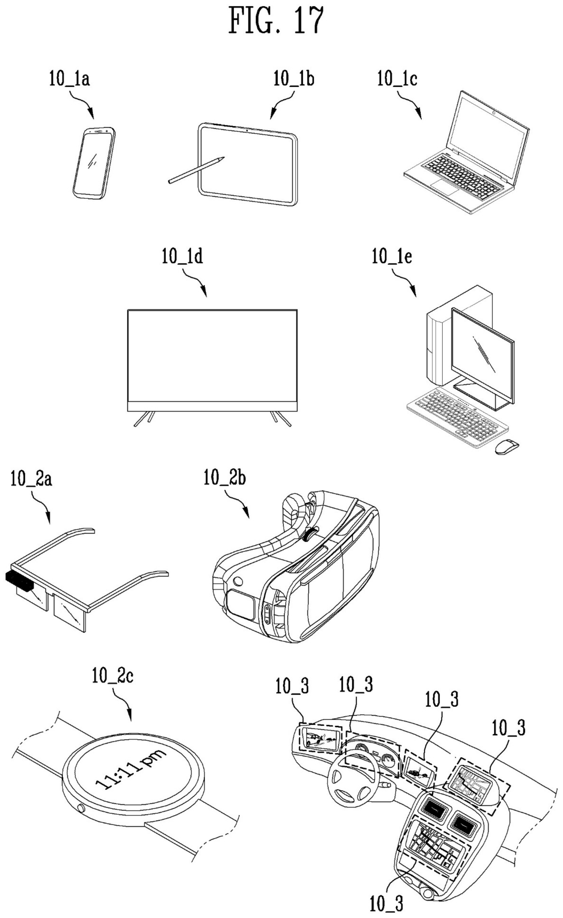

FIG. 17 shows schematic views of various embodiments of an electronic device.

Referring to FIG. 17, various types of electronic devices to which embodiments of the display device are applied may include an electronic device to display images such as a smartphone 10_1a, a tablet PC 10_1b, a laptop computer 10_1c, a television (TV) 10_1d, and a desktop monitor 10_1e, a wearable electronic device including a display module such as smart glasses 10_2a, a head-mounted display (HMD) 10_2b, and a smart watch 10_2c, and an automotive electronic device 10_3 including a display module such as a center information display (CID) arranged at the instrument cluster, the center fascia, and the dashboard of a vehicle, and a room mirror display.

According to some embodiments of the present disclosure, leakage current between adjacent sub-pixels is blocked to prevent or reduce degradation of image quality due to coloration or luminance degradation.

According to some embodiments of the present disclosure, a reduction in the step difference in a cathode may lead to a decrease in IR drop to thereby relatively increase power efficiency.

However, the aspects and features of embodiments according to the present disclosure are not limited to those described above, and various other aspects and features as would be understood by those having ordinary skill in the art may be included in the scope of embodiments according to the present disclosure.

The foregoing is illustrative of some embodiments of the present disclosure, and is not to be construed as limiting thereof. Although aspects of some embodiments have been described, those skilled in the art will readily appreciate that various modifications are possible in the embodiments without departing from the scope of the present disclosure. It will be understood that descriptions of features or aspects within each embodiment should typically be considered as available for other similar features or aspects in other embodiments, unless otherwise described. Thus, as would be apparent to one of ordinary skill in the art, features, characteristics, and/or elements described in connection with a particular embodiment may be used singly or in combination with features, characteristics, and/or elements described in connection with other embodiments unless otherwise specifically indicated. Therefore, it is to be understood that the foregoing is illustrative of various example embodiments and is not to be construed as limited to the specific embodiments disclosed herein, and that various modifications to the disclosed embodiments, as well as other example embodiments, are intended to be included within the scope of the present disclosure as defined in the appended claims, and their equivalents.

## Claims

1. A display device (100), comprising:
a first anode (AE1) and a second anode (AE2) spaced apart from the first anode (AE1); and
a pixel defining layer (PDL) on the first anode (AE1) and the second anode (AE2) and including openings (OP) exposing portions of the first anode (AE1) and the second anode (AE2), respectively,
wherein the pixel defining layer (PDL) comprises:
a first pixel defining layer (PDL1) having a first taper angle (a1) and a first width (w1);
a second pixel defining layer (PDL2) on the first pixel defining layer (PDL1) and having a second taper angle (a2) and a second width (w2) less than the first width (w1); and
a third pixel defining layer (PDL3) on the second pixel defining layer (PDL2) and having a third taper angle (a3) and a third width (w3), and
wherein each of the first taper angle (a1), the second taper angle (a2), and the third taper angle (a3) is an acute angle.

2. The display device (100) according to claim 1, wherein the third width (w3) is less than the first width (w1) and greater than the second width (w2).

3. The display device (100) according to claim 2, wherein a difference between a (1-1)th thickness (t1-1) of a first portion of the first pixel defining layer (PDL1) overlapping with the second pixel defining layer (PDL2) and the third pixel defining layer and a (1-2)th thickness (t1-2) of a second portion of the first pixel defining layer (PDL1) overlapping with the third pixel defining layer (PDL3) and not overlapping with the second pixel defining layer (PDL2) is 10% or less of the (1-1)th thickness (t1-1), and
wherein the difference between the (1-1)th thickness (t1-1) and a (1-3)th thickness (t1-3) of a third portion of the first pixel defining layer (PDL1) not overlapping with the second pixel defining layer (PDL2) and the third pixel defining layer (PDL3) is 10% or less of the (1-1)th thickness (t1-1), optionally wherein a fourth width (w4) of the third portion of the first pixel defining layer (PDL1) is greater than or equal to 70 nanometers.

4. The display device (100) according to claim 3, wherein the second pixel defining layer (PDL2) and the third pixel defining layer (PDL3) form an undercut structure.

5. The display device (100) according to claim 4, wherein a sum of a second thickness (t2) of the second pixel defining layer (PDL2) and a third thickness (t3) of the third pixel defining layer (PDL3) is 1000 angstroms or less.

6. The display device (100) according to claim 5, wherein a fifth width (w5) of the second portion of the first pixel defining layer (PDL1) is less than a sixth width (w6) of a lower surface of the third pixel defining layer (PDL3) not in contact with the second pixel defining layer (PDL2), optionally wherein the sixth width (w6) is at least 1.5 times and less than or equal to 2.5 times the second thickness (t2).

7. The display device (100) according to any one of claims 1 to 6, wherein the first pixel defining layer (PDL1) and the third pixel defining layer (PDL3) each comprise silicon oxide, and the second pixel defining layer (PDL2) comprises silicon nitride.

8. The display device (100) according to any one of claims 1 to 7, wherein the second pixel defining layer (PDL2) comprises:
a (2-1)th pixel defining layer (PDL2-1) having a first film density; and
a (2-2)th pixel defining layer (PDL2-2) on the (2-1)th pixel defining layer (PDL2-1) and having a second film density less than the first film density, optionally wherein the (2-1)th pixel defining layer (PDL2-1) and the (2-2)th pixel defining layer (PDL2-2) comprise a same material.

9. The display device (100) according to claim 1, wherein the third width (w3) is equal to the first width (w1).

10. The display device according to any one of claims 2 to 9, wherein a portion of the first pixel defining layer (PDL1) not overlapping the second pixel defining layer (PDL2) and the third pixel defining layer (PDL3) has a step difference.

11. A display device (100), comprising:
a first anode (AE1) and a second anode (AE2) spaced apart from the first anode (AE1); and
a pixel defining layer (PDL) on the first anode (AE1) and the second anode (AE2) and including openings (OP) exposing portions of the first anode (AE1) and the second anode (AE2), respectively,
wherein the pixel defining layer (PDL) comprises:
a first pixel defining layer (PDL2) having a first taper angle (a2) and a first width (w2); and
a second pixel defining layer (PDL3) on the first pixel defining layer (PDL2) and having a second taper angle (a3) and a second width (w3) greater than the first width (w2), and
wherein each of the first taper angle (a2) and the second taper angle (a3) is an acute angle.

12. The display device (100) according to claim 11, wherein the first pixel defining layer (PDL2) and the second pixel defining layer (PDL3) form an undercut structure.

13. The display device (100) according to claim 12, wherein a sum of a first thickness (t2) of the first pixel defining layer (PDL2) and a second thickness (t3) of the second pixel defining layer (PDL3) is 1000 angstroms or less, optionally wherein a third width (w6) of a lower surface of the second pixel defining layer (PDL3) not in contact with the first pixel defining layer (PDL2) is at least 1.5 times and less than or equal to 2.5 times the first thickness (t2).

14. The display device (100) according to any one of claims 11 to 13, wherein the first pixel defining layer (PDL2) comprises silicon nitride, and the second pixel defining layer (PDL3) comprises silicon oxide.

15. An electronic device (10), comprising:
a processor (12) configured to provide an image data signal; and
a display device (100) configured to display an image based on the image data signal,
wherein the display device (100) comprises:
a first anode (AE1) and a second anode (AE2) spaced apart from the first anode (AE1); and
a pixel defining layer (PDL) on the first anode (AE1) and the second anode (AE2) and including openings (OP) exposing portions of the first anode (AE1) and the second anode (AE2), respectively,
wherein the pixel defining layer (PDL) comprises:
a first pixel defining layer (PDL1) having a first taper angle (a1) and a first width (w1);
a second pixel defining layer (PDL2) on the first pixel defining layer (PDL1) and having a second taper angle (a2) and a second width (w2) less than the first width (w1); and
a third pixel defining layer (PDL3) on the second pixel defining layer (PDL2) and having a third taper angle (a3) and a third width (w3), and
wherein each of the first taper angle (a1), the second taper angle (a2), and the third taper angle (a3) is an acute angle, optionally wherein the second pixel defining layer (PDL2) and the third pixel defining layer (PDL3) form an undercut structure.
